(19) Europäisches Patentamt / European Patent Office / Office européen des brevets

(11) **EP 4 361 098 A1**

(12) **EUROPEAN PATENT APPLICATION**

(43) Date of publication:
**01.05.2024 Bulletin 2024/18**

(21) Application number: **23205033.6**

(22) Date of filing: **20.10.2023**

(51) International Patent Classification (IPC):
**C01B 32/162** (2017.01)  **B01J 23/74** (2006.01)
**B01J 23/76** (2006.01)  **B01J 35/32** (2024.01)
**B01J 35/51** (2024.01)  **B01J 37/08** (2006.01)
**H01M 10/00** (2006.01)

(52) Cooperative Patent Classification (CPC):
**C01B 32/162; B01J 23/74; B01J 23/76;**
**B01J 35/32; B01J 35/51; B01J 37/082;**
**H01M 10/00;** C01B 32/174; C01B 2202/08;
C01B 2202/22; C01B 2202/30; C01B 2202/32;
C01B 2202/34; C01B 2202/36; C01P 2006/10

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **21.10.2022 KR 20220136552**

(71) Applicant: **Korea Kumho Petrochemical Co., Ltd.**
**Seoul 04542 (KR)**

(72) Inventors:
• **JEONG, Myung Hoon**
**28630 Cheongju-si, Chungcheongbuk-do (KR)**

• **KIM, Hyun Tae**
**04369 Seoul (KR)**
• **RYU, Sang Hyo**
**04720 Seoul (KR)**
• **JEONG, Chung Heon**
**34061 Daejeon (KR)**
• **LEE, Wan Sung**
**34048 Daejeon (KR)**
• **JUNG, Woo Ram**
**34049 Daejeon (KR)**
• **KANG, Chang Gu**
**34011 Daejeon (KR)**

(74) Representative: **Beck & Rössig**
**European Patent Attorneys**
**Denninger Str. 169**
**81925 München (DE)**

(54) **PREPARING METHOD OF CATALYST FOR PREPARING LOW-DIAMETER CARBON NANOTUBE AND PREPARING METHOD OF CARBON NANOTUBE USING SAME**

(57) A method for preparing a catalyst for preparing a carbon nanotube, comprises: (a) dissolving a main catalyst precursor, a support precursor, a cocatalyst precursor and a precipitation inhibitor in a solvent to prepare a precursor solution; and (b) pyrolyzing the precursor solution by spraying the precursor solution into a reactor, wherein a mole fraction of the precipitation inhibitor to the cocatalyst precursor is 0.1 to 1.5. Further disclosed are a catalyst for preparing a carbon nanotube, a method for preparing a carbon nanotube, and a carbon nanotube.

**FIG. 1**

EP 4 361 098 A1

## Description

### Technical field

The present invention relates to a method for preparing a catalyst for preparing a low-diameter carbon nanotube, a catalyst for preparing a carbon nanotube prepared thereby, a method for preparing a low-diameter carbon nanotube, and a carbon nanotube prepared thereby.

### Background art

As the interest and demand for eco-friendly energy and electric vehicles are on the rise, the demand for a secondary battery and the necessity for improving the performance thereof are rapidly increasing. Especially, the secondary battery for electric vehicles is required to be a high-capacity secondary battery with a high energy density, a long lifespan and a low self-discharge rate. In order to secure such physical properties, it is essential to develop conductive materials with high electrical conductivity.

As a conductive material which serves as a passage of electric charges inside the battery, a carbon-based conductive material, for example, graphite, carbon black, graphene, carbon nanotubes, etc. may be used. Conventionally, conductive carbon black was mainly used.

A carbon nanotube is a material having a tube-type structure formed in a hexagonal honeycomb-shaped lattice in which one carbon atom is bonded to three other carbon atoms. Due to its excellent electrical conductivity, carbon nanotube is spotlighted as a next-generation conductive material for the secondary battery. When carbon nanotube is used as a conductive material, the energy density and lifespan characteristics of the secondary battery may be improved, thereby reducing the size of the battery.

Meanwhile, as the carbon nanotube has a smaller diameter, it exhibits more excellent electrical conductivity. Therefore, the use of a low-diameter carbon nanotube as a conductive material for a secondary battery may further improve the capacity and lifespan characteristics of the secondary battery. Accordingly, there is a demand developing a technology for preparing a catalyst for synthesizing a carbon nanotube having a diameter smaller than that of a conventional carbon nanotube and a carbon nanotube prepared using the same.

### Technical Problem

The description of the present specification is intended to solve the problems of the prior art described above. It is an object of the present specification to provide a catalyst for preparing a carbon nanotube capable of synthesizing a low-diameter carbon nanotube and a method for preparing the same.

It is another object of the present specification to provide a low-diameter carbon nanotube with excellent electrical conductivity and a method for preparing the same.

### Technical Solution

According to an aspect, the present specification provides a method for preparing a catalyst for preparing a carbon nanotube, comprising: (a) dissolving a main catalyst precursor, a support precursor, a cocatalyst precursor and a precipitation inhibitor in a solvent to prepare a precursor solution; and (b) pyrolyzing the precursor solution by spraying the precursor solution into a reactor, wherein a mole fraction of the precipitation inhibitor to the cocatalyst precursor is 0.1 to 1.5.

In a preferred embodiment, the main catalyst precursor may be at least one metal precursor selected from Co, Fe and Ni.

In a preferred embodiment, the support precursor may be at least one metal precursor selected from Al, Ca and Mg.

In a preferred embodiment, the cocatalyst precursor may be at least one metal precursor selected from V, Mn and Mo.

In a preferred embodiment, the precipitation inhibitor may be one selected from the group consisting of citric acid, tricarballylic acid, mercaptosuccinic acid, succinic acid and combinations thereof.

According to another aspect, the present specification provides a catalyst for preparing a carbon nanotube, prepared by the method for preparing a catalyst for preparing a carbon nanotube.

In a preferred embodiment, the catalyst for preparing a carbon nanotube may have a bulk density of 0.02 to 0.2 g/ml.

In a preferred embodiment, the catalyst for preparing a carbon nanotube may have a spherical particle morphology.

According to another aspect, the present specification provides a method for preparing a carbon nanotube, comprising: (1) introducing the catalyst for preparing a carbon nanotube into a chemical vapor deposition reactor; and (2) injecting a carbon source gas to synthesize a carbon nanotube.

In a preferred embodiment, the carbon source gas may comprise one selected from the group consisting of unsaturated or saturated hydrocarbon having 1 to 4 carbon atoms, carbon monoxide and mixtures of two or more thereof.

According to yet another aspect, the present specification provides a carbon nanotube prepared by the method for preparing a carbon nanotube.

In an embodiment, the carbon nanotube may have a diameter of 7 to 12 nm.

In an embodiment, the carbon nanotube may have a purity of 90% or more.

In an embodiment, the carbon nanotube may have a bundle length of 50 to 200 $\mu$m.

In an embodiment, the carbon nanotube may have a BET specific surface area of 250 to 400 $m^2/g$.

In a preferred embodiment, the carbon nanotube may have a bulk density of 0.005 to 0.5 g/ml.

## Advantageous Effects

As one effect of many effects, the present specification may provide a catalyst for preparing a carbon nanotube, which can be used for synthesizing a low-diameter carbon nanotube having a diameter smaller than that of a conventional carbon nanotube.

As another effect of many effects, the present specification may prevent precipitation of catalyst components while preparing a catalyst precursor solution, thereby preparing a catalyst for preparing a carbon nanotube with a high yield.

As yet another effect of many effects, the present specification may synthesize a low-diameter carbon nanotube with a high purity.

As yet another effect of many effects, the present specification may provide a carbon nanotube having a small diameter and thus having excellent electrical conductivity, thereby improving capacity and lifespan characteristics of a secondary battery when used as a conductive material for a secondary battery.

The effects of the present specification are not limited to the above-mentioned effects, and it should be understood that the effects of the present specification include all effects that could be inferred from the configuration described in the detailed description of the specification or the appended claims.

## Description of drawings

Fig. 1 is an SEM image of a catalyst prepared according to Example 1 of the present specification;
Fig. 2 is an SEM image of a catalyst prepared according to Example 2 of the present specification;
Fig. 3 is an SEM image of a catalyst prepared according to Example 3 of the present specification;
Fig. 4 is an SEM image of a catalyst prepared according to Comparative Example 3 of the present specification; and
Fig. 5 is an SEM image of a catalyst prepared according to Comparative Example 4 of the present specification.

## Modes of the Invention

Hereinafter, an aspect of the present specification will be explained with reference to the accompanying drawing. The description of the present specification, however, may be modified in different ways, and should not be construed as limited to the embodiments set forth herein. Also, in order to clearly explain an aspect of the present specification in the drawing, portions that are not related to the explanation are omitted, and like reference numerals are used to refer to like elements throughout the specification.

Throughout the specification, it should be understood that when a portion is referred to as being "connected" to another portion, it can be "directly connected to" the other portion, or "indirectly connected to" the other portion having intervening portions present. Also, when a component "includes" an element, unless there is another opposite description thereto, it should be understood that the component does not exclude another element but may further include another element.

When a range of numerical values is described herein, the value has the precision of the significant figures provided according to the standard rules in chemistry for significant figures, unless a specific range thereof is stated otherwise. For example, 10 includes a range of 5.0 to 14.9 and the number 10.0 includes a range of 9.50 to 10.49.

Hereinafter, an embodiment of the present specification will be described in detail with reference to the accompanying drawing.

Method for preparing catalyst for preparing carbon nanotube

A method for preparing a catalyst for preparing a carbon nanotube according to an aspect of the present specification comprises (a) dissolving a main catalyst precursor, a support precursor, a cocatalyst precursor and a precipitation inhibitor in a solvent to prepare a precursor solution; and (b) pyrolyzing the precursor solution by spraying the precursor solution into a reactor, wherein a mole fraction of the precipitation inhibitor to the cocatalyst precursor is 0.1 to 1.5.

The crystal structure of a catalyst for preparing a carbon nanotube may vary depending on the method for preparing the catalyst or ratio between the components of the catalyst, and the growth morphology and characteristics of the carbon nanotube synthesized using the catalyst may vary depending on the crystal structure of the catalyst.

The method for preparing a catalyst for preparing a carbon nanotube uses spray pyrolysis. The thus prepared catalyst may have a spherical particle morphology and have a lower bulk density compared to a catalyst prepared by supporting method.

In addition, the catalyst prepared using spray pyrolysis may have a hollow structure. In this case, the hollow structure may have a thickness of 0.5 to 10 $\mu$m, preferably 1 to 8 $\mu$m, and the hollow ratio may be 50 vol % or more. As used herein, a hollow structure refers to a three-dimensional structure that is hollow inside, for example, a spherical or polyhedral structure that is hollow inside, including a closed structure where all of the hollows are enclosed, an open structure where some of the hollows are open, or a combination thereof. If the catalyst has a hollow structure as shown above, it may be advantageous for the synthesis of low-diameter carbon nanotubes.

A low-diameter carbon nanotube having a diameter smaller than that of a conventional carbon nanotube may be synthesized using a catalyst prepared by the method described above, and the low-diameter carbon nanotube may have a diameter of 7 to 12 nm. The carbon nanotube synthesized using a catalyst prepared by the above method exhibits a low bulk density and excellent electrical conductivity, and accordingly, may improve capacity and lifespan characteristics of a secondary battery when used as a conductive material for a secondary battery.

The method for preparing a catalyst for preparing a carbon nanotube inhibits precipitation of catalyst components while preparing a precursor solution, thereby preparing a catalyst for preparing a carbon nanotube with a high yield.

According to the method for preparing a catalyst for preparing a carbon nanotube, the catalyst may be prepared with a yield of 90% or more. For example, the yield may be 90%, 91%, 92%, 93%, 94%, 95% or more, but is not limited thereto. When the catalyst preparation yield is less than the above range, the economics of the catalyst preparation process may be compromised.

The method for preparing a catalyst for preparing a carbon nanotube may be used in synthesis of a low-diameter carbon nanotube having a diameter smaller than that of a conventional carbon nanotube by adjusting a mole fraction of a precipitation inhibitor to a cocatalyst precursor. The carbon nanotube synthesized using the catalyst prepared by the method described above may have a diameter of 7 to 12 nm, and exhibit a low bulk density and excellent electrical conductivity, thereby improving capacity and lifespan characteristics of a secondary battery when used as a conductive material for a secondary battery.

A mole fraction of the precipitation inhibitor to the cocatalyst precursor may be, for example, 0.1, 0.2, 0.3, 0.4, 0.5, 0.6, 0.7, 0.8, 0.9, 1.0, 1.1, 1.2, 1.3, 1.4, 1.5 or a range between any two of these values. When the mole fraction of the precipitation inhibitor to the cocatalyst precursor is less than the above range, catalyst components can be precipitated while preparing a precursor solution, and accordingly, a catalyst for preparing a carbon nanotube may not be prepared. When the mole fraction of the precipitation inhibitor to the cocatalyst precursor exceeds the above range, the catalyst preparation yield may decrease, the carbon nanotube synthesized using the prepared catalyst may have a greater diameter, and electrical conductivity may decrease, and accordingly, the carbon nanotube may be unsuitable as a conductive material for a secondary battery.

Step (a), which is a step of preparing a precursor solution comprising precursors of metal components included in the catalyst for preparing a carbon nanotube, may include introducing a main catalyst precursor, a support precursor, a cocatalyst precursor and a precipitation inhibitor into a solvent, and stirring under nitrogen atmosphere.

The main catalyst precursor may be at least one metal precursor selected from Co, Fe and Ni, but is not limited thereto.

The support precursor may be at least one metal precursor selected from Al, Ca and Mg, but is not limited thereto.

The cocatalyst precursor may be at least one metal precursor selected from V, Mn and Mo, but is not limited thereto.

The metal precursor may be one selected from the group consisting of nitrate, sulphate, alkoxide, chloride, acetate, carbonate of each metal and mixtures of two or more thereof, but is not limited thereto.

The precipitation inhibitor easily dissolves a main catalyst precursor, a support precursor and a cocatalyst precursor in a solvent.

The precipitation inhibitor may be an organic acid, for example, carboxylic acid, but is not limited thereto.

The precipitation inhibitor may be one selected from the group consisting of citric acid, tricarballylic acid, mercaptosuccinic acid, succinic acid and combinations thereof, but is not limited thereto.

In step (a), the solvent may be a polar solvent, and as the polar solvent, water, methanol, ethanol, propanol, isopropanol, butanol, or mixtures of two or more thereof may be used, for example, deionized water may be used, but the solvent is not limited thereto. The use of deionized water as the solvent may minimize impurities in the precursor solution, thereby improving the purity of the catalyst finally prepared. The improved purity of the catalyst may result in improved purity of carbon nanotubes.

Step (b) may include (b1) spraying the precursor solution with a carrier gas into a reactor; and (b2) pyrolyzing the sprayed precursor solution at 600 to 1,200°C.

In step (b1), in order to control the particle morphology, bulk density, etc., of the catalyst, the precursor solution may be converted into finer droplets by spraying the precursor solution into the reactor.

In step (b1), the carrier gas may be air, but is not limited thereto.

In step (b2), a catalyst may be prepared by heating the droplets to evaporate the solvent and decompose the precursors.

In step (b2), the temperature of the reactor may be 600 to 1,200°C. For example, the temperature may be 600°C, 650°C, 700°C, 750°C, 800°C, 850°C, 900°C, 950°C, 1,000°C, 1,050°C, 1,100°C, 1,150°C, 1,200°C or a range between any two of these values. When the temperature of the reactor is lower than the above range, the catalyst is poorly dried and thus an additional process is required, which is economically disadvantageous, and the carbon nanotubes synthesized using the same may have decreased purity or physical properties. When the temperature of the reactor is higher than the above range, excessive costs are required for equipment or facilities, which causes economic loss, and also the performance of the catalyst may be degraded due to formation of a solid solution or deformation of the crystal structure.

Catalyst for preparing carbon nanotube

A catalyst for preparing a carbon nanotube according to another aspect of the present specification is prepared by the method for preparing a catalyst for preparing a carbon nanotube described above.

The catalyst for preparing a carbon nanotube may have a bulk density of 0.02 to 0.2 g/ml. For example, the bulk density may be 0.02 g/ml, 0.03 g/ml, 0.04 g/ml, 0.05 g/ml, 0.06 g/ml, 0.07 g/ml, 0.08 g/ml, 0.09 g/ml, 0.10 g/ml, 0.11 g/ml, 0.12 g/ml, 0.13 g/ml, 0.14 g/ml, 0.15 g/ml, 0.16 g/ml, 0.17 g/ml, 0.18 g/ml, 0.19 g/ml, 0.20 g/ml or a range between any two of these values. The bulk density may be measured using a catalyst in the form of powder. When the bulk density is out of the above range, the carbon nanotube synthesized using the catalyst has decreased synthesis yield and purity, or a greater diameter, which may be unsuitable as a conductive material for a secondary battery.

The catalyst for preparing a carbon nanotube may have a spherical particle morphology. The spherical catalyst particle may have an average aspect ratio of 1.2 or less. The aspect ratio refers to a value calculated by dividing the length of the longest portion (major axis length) of the catalyst particle by the length of the shortest portion (minor axis length).

The catalyst for preparing a carbon nanotube may have a porous structure with pores, and the pore may be 1 to 10 nm in size.

Method for preparing carbon nanotube

A method for preparing a carbon nanotube according to another aspect of the present specification comprises (1) introducing the catalyst for preparing a carbon nanotube described above into a chemical vapor deposition reactor; and (2) injecting a carbon source gas to synthesize a carbon nanotube.

The chemical vapor deposition reactor may be a fixed-bed chemical vapor deposition reactor or a fluidized-bed chemical vapor deposition reactor, but is not limited thereto.

The carbon source gas may comprise one selected from the group consisting of unsaturated or saturated hydrocarbon having 1 to 4 carbon atoms, carbon monoxide and mixtures of two or more thereof. For example, the carbon source gas may include methane ($CH_4$), ethane ($C_2H_6$), ethylene ($C_2H_4$), propane ($C_3H_8$), butane ($C_4H_{10}$), acetylene ($C_2H_2$), carbon monoxide (CO) or mixtures of two or more thereof, but is not limited thereto.

In step (2), the internal temperature of the chemical vapor deposition reactor may be 600 to 1,000°C. For example, the temperature may be 600°C, 650°C, 700°C, 750°C, 800°C, 850°C, 900°C, 950°C, 1,000°C or a range between any two of these values. When the internal temperature of the reactor is lower than the above range, the growth of carbon nanotubes may be impossible or delayed. When the internal temperature exceeds the above range, the synthesized carbon nanotubes may be pyrolyzed or interconnected with each other, which makes it impossible to maintain the morphology thereof.

The ratio of a flow rate (L/min) of the carbon source gas to an input (g) of the catalyst for preparing a carbon nanotube may be 0.1 to 1.1 L/g·min. For example, the ratio may be 0.1 L/g·min, 0.2 L/g·min, 0.3 L/g min, 0.4 L/g·min, 0.5 L/g·min, 0.6 L/g·min, 0.7 L/g·min, 0.8 L/g min, 0.9 L/g min, 1.0 L/g min, 1.1 L/g min or a range between any two of these values. When the ratio of the carbon source gas flow rate to the catalyst input is less than the above range, catalytic activity may be too low to synthesize a carbon nanotube. When the ratio exceeds the above range, the synthesized carbon nanotube has a greater diameter and decreased electrical conductivity, which may be unsuitable as a conductive material for a secondary battery.

In step (2), the carbon source gas may be injected with a carrier gas. The carrier gas may be one selected from the group consisting of helium, nitrogen, argon and mixtures of two or more thereof, but is not limited thereto.

In step (2), a carbon nanotube may be synthesized while the carbon source gas decomposed by heat of a high temperature permeates the catalyst to be saturated, and then carbon is precipitated.

Carbon nanotube

A carbon nanotube according to yet another aspect of the present specification is prepared by the method for preparing a carbon nanotube described above.

The carbon nanotube may have a diameter of 7 to 12 nm. For example, the diameter may be 7 nm, 8 nm, 9 nm, 10 nm, 11 nm, 12 nm or a range between any two of these values. When the diameter is less than the above range, the carbon nanotube may have structural defects or degraded dispersibility. When the diameter exceeds the above range, the carbon nanotube may have decreased electrical conductivity, which may reduce the energy density, lifespan characteristics and self-discharge rate of a secondary battery when used as a conductive material for a secondary battery.

The carbon nanotube may have a purity of 90% or more. When the purity is less than the above range, electrical conductivity may decrease, and when the carbon nanotube is used as a conductive material for a secondary battery, impurities react inside the battery, which may cause safety accidents.

The carbon nanotubes may be formed such that a plurality of carbon nanotubes are aggregated into bundles, but are not limited thereto.

The carbon nanotube may have a bundle length of 50 to 200 $\mu$m. For example, the bundle length may be 50 $\mu$m, 60 $\mu$m, 70 $\mu$m, 80 $\mu$m, 90 $\mu$m, 100 $\mu$m, 110 $\mu$m, 120 $\mu$m, 130 $\mu$m, 140 $\mu$m, 150 $\mu$m, 160 $\mu$m, 170 $\mu$m, 180 $\mu$m, 190 $\mu$m, 200 $\mu$m or a range between any two of these values. When the bundle length is less than the above range, the carbon nanotube has decreased electrical conductivity, which may be unsuitable as a conductive material for a secondary battery. When the bundle length exceeds the above range, dispersibility may decrease.

The carbon nanotube may have a BET specific surface area of 250 to 400 $m^2$/g. For example, the BET specific surface area may be 250 $m^2$/g, 260 $m^2$/g, 270 $m^2$/g, 280 $m^2$/g, 290 $m^2$/g, 300 $m^2$/g, 310 $m^2$/g, 320 $m^2$/g, 330 $m^2$/g, 340 $m^2$/g, 350 $m^2$/g, 360 $m^2$/g, 370 $m^2$/g, 380 $m^2$/g, 390 $m^2$/g, 400 $m^2$/g or a range between any two of these values. When the BET specific surface area is less than the above range, the carbon nanotube has decreased electrical conductivity, which may be unsuitable as a conductive material for a secondary battery. When the BET specific surface area exceeds the above range, dispersibility may decrease.

The carbon nanotube may have a bulk density of 0.005 to 0.5 g/ml. For example, the bulk density may be 0.005 g/ml, 0.01 g/ml, 0.02 g/ml, 0.03 g/ml, 0.04 g/ml, 0.05 g/ml, 0.06 g/ml, 0.07 g/ml, 0.08 g/ml, 0.09 g/ml, 0.1 g/ml, 0.2 g/ml, 0.3 g/ml, 0.4 g/ml, 0.5 g/ml or a range between any two of these values. The bulk density may be measured using a carbon nanotube in the form of powder. When the bulk density is less than the above range, dispersibility may decrease. When the bulk density exceeds the above range, the carbon nanotube has decreased electrical conductivity, which may be unsuitable as a conductive material for a secondary battery.

The carbon nanotube exhibits excellent electrical conductivity, and thus may exhibit the same or more improved performance than a conventional carbon nanotube even in a small amount when used as a conductive material for a secondary battery. Accordingly, the carbon nanotube may be applied to the production of a high capacity secondary battery with a high energy density, a long lifespan and a low self-discharge rate.

Hereinafter, examples of the present specification will be described in more detail. However, the following experimental results describe only representative experimental results among the examples and the scope and content of the present specification may not be construed as narrowed or limited by the examples. Each effect of the various embodiments of the present specification not explicitly presented below will be specifically described in the corresponding section.

Example 1

A precursor mixed solution was prepared by dissolving 0.78 mol of $Co(NO_3)_3 \cdot 6H_2O$, 2.28 mol of $Al(NO_3)_3 \cdot 9H_2O$, 0.09 mol of $NH_4VO_3$ and 0.135 mol of citric acid in deionized water. Afterwards, the precursor mixed solution was sprayed into a reactor of 750°C for pyrolysis to prepare a catalyst.

Example 2

A catalyst was prepared in the same manner as in Example 1, except that 0.09 mol of citric acid was used.

Example 3

A catalyst was prepared in the same manner as in Example 1, except that 0.009 mol of citric acid was used.

Comparative Example 1

A catalyst was prepared in the same manner as in Example 1, except that 0.2 mol of citric acid was used.

Comparative Example 2

A catalyst was prepared in the same manner as in Example 1, except that 0.0072 mol of citric acid was used.

Comparative Example 3

A precursor mixed solution was prepared by dissolving 0.78 mol of $Co(NO_3)_3 \cdot 6H_2O$, 0.09 mol of $NH_4VO_3$ and 0.09 mol of citric acid in deionized water. The precursor mixed solution was sufficiently supported in alumina ($Al_2O_3$), which is a solid support, and then sintered at 700°C for 3 hours to prepare a supported catalyst.

Comparative Example 4

A supported catalyst was prepared in the same manner as in Comparative Example 3, except that 0.009 mol of citric acid was used.
Table 1 below shows the content of citric acid, the mole fraction of citric acid to cocatalyst and the method for preparing the catalyst used in Examples 1 to 3 and Comparative Examples 1 to 4.

[Table 1]

| | Example 1 | Example 2 | Example 3 | Comparative Example 1 | Comparative Example 2 | Comparative Example 3 | Comparative Example 4 |
|---|---|---|---|---|---|---|---|
| Content of citric acid (mol) | 0.135 | 0.09 | 0.009 | 0.2 | 0.0072 | 0.09 | 0.009 |
| Citric acid/cocatalyst (mole fraction) | 1.5 | 1 | 0.1 | 2.2 | 0.08 | 1 | 0.1 |
| Method of preparing catalyst | Pyrolysis | Pyrolysis | Pyrolysis | Pyrolysis | Pyrolysis | Supporting | Support -ing |

Preparation Example

The catalysts prepared according to Examples 1 to 3 and Comparative Examples 1 to 4 described above were introduced into a 350 mm fluidized-bed chemical vapor deposition reactor, the internal temperature of the reactor was raised to 650 to 800°C under nitrogen atmosphere, and a carbon source gas was injected to synthesize carbon nanotubes. In this case, the flow rate of the carbon source gas was constantly maintained at 0. 3 L/min per 1 g of the input of catalyst.

Experimental Example 1

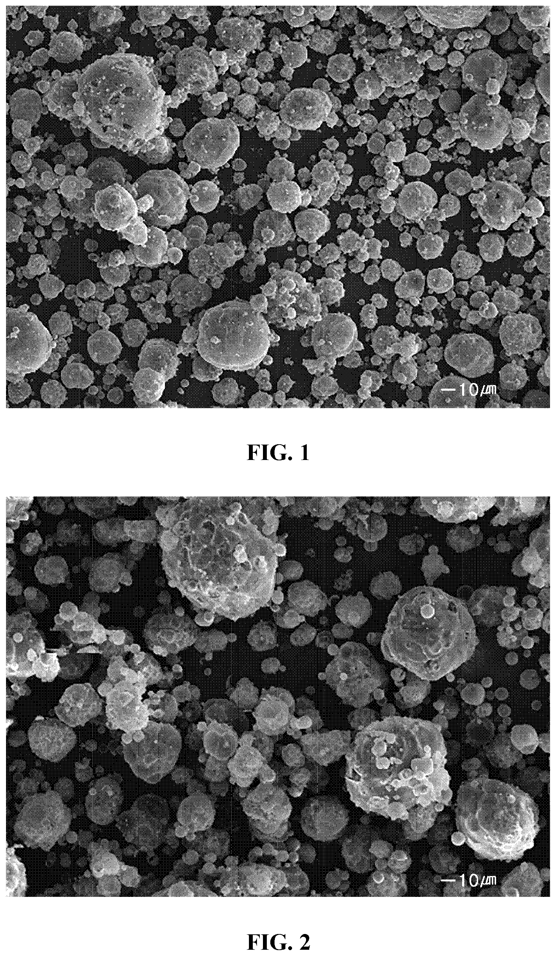

The particle morphology, preparation yield and bulk density of the catalysts prepared according to Examples and Comparative Examples described above were measured, and the results thereof were shown in Tables 2 and 3 below, and Figs. 1 to 5.

1) Particle morphology: The particle morphology was measured at 300x magnification using FE-SEM (JEOL, JSM-7500F).
Figs. 1 to 5 illustrate the SEM images of the catalysts prepared according to Examples 1 to 3 and Comparative Examples 3 and 4, respectively.
2) Preparation yield: The preparation yield means the amount of prepared catalyst relative to the total amount of metal components in the raw materials, and was calculated according to the following equation.

$$\text{Preparation yield (\%) = amount (g) of prepared catalyst/total amount (g) of metal}$$

$$\text{components in the raw materials} \times 100$$

3) Bulk density: A 100 ml container with a known weight was filled with catalyst powder and weighed, and then the bulk density was converted according to the following equation.

$$\text{Bulk density = total amount (g) of prepared catalyst/volume (ml) of prepared catalyst}$$

Experimental Example 2

The catalyst yield, average diameter and bulk density of carbon nanotubes synthesized according to Preparation Example described above were measured, and the results thereof were shown in Tables 2 and 3 below.
1) Catalyst yield: The catalyst yield means the total amount of carbon nanotubes synthesized relative to the input of catalyst, and was calculated according to the following equation.

$$\text{Catalyst yield (\%) = total amount (g) of synthesized carbon nanotubes/input (g) of}$$

$$\text{catalyst} \times 100$$

2) Average diameter: The average diameter was measured at 200,000x magnification using TEM (JEOL, JEM-2100F).
3) Bulk density: A 100 ml container with a known weight was filled with catalyst powder and weighed, and then the bulk density was converted according to the following equation.

$$\text{Bulk density = total amount (g) of synthesized carbon nanotubes/volume (ml) of}$$

$$\text{synthesized carbon nanotubes}$$

[Table 2]

| | | Example 1 | Example 2 | Example 3 | Comparative Example 1 | Comparative Example 2 |
|---|---|---|---|---|---|---|
| Catalyst | Particle morphology | spherical | spherical | spherical | spherical | - |
| | Preparation yield (%) | 95 | 95 | 95 | 82 | Synthesizing is impossible (precipitation) |
| Carbon nanotube | Catalyst yield (%) | 1182 | 1279 | 1099 | 1198 | - |
| | Average diameter (nm) | 7.2 | 8.1 | 8.2 | 12.7 | - |

Referring to Table 2 above, the catalysts prepared according to Examples 1 to 3 exhibited a high catalyst preparation yield of 95%. The carbon nanotubes synthesized using each catalyst exhibited a high catalyst yield while having a reduced diameter of 7 to 12 nm.

The catalyst prepared according to Comparative Example 1 in which citric acid, a precipitation inhibitor, was introduced in an excessive amount, exhibited a decreased catalyst preparation yield, and the carbon nanotubes synthesized using the corresponding catalyst had a diameter exceeding 12 nm.

In the case of Comparative Example 2 in which citric acid, a precipitation inhibitor, was introduced in a small amount, catalyst particles were not synthesized due to precipitation of the catalyst component during the preparation of the precursor solution.

[Table 3]

| | | Example 1 | Example 2 | Example 3 | Comparative Example 3 | Comparative Example 4 |
|---|---|---|---|---|---|---|
| Catalyst | Particle morphology | spherical | spherical | spherical | granular | granular |
| | Bulk density (g/ml) | 0.121 | 0.098 | 0.124 | 0.8542 | 0.9512 |
| Carbon nanotube | Average diameter (nm) | 7.2 | 8.1 | 8.2 | 13.8 | 14.1 |
| | Bulk density (g/ml) | 0.01 | 0.01 | 0.01 | 0.039 | 0.031 |

Referring to Table 3 above and Figs. 1 to 3, all of the catalysts prepared according to Examples 1 to 3 had spherical particle morphology, and exhibited low bulk density compared to those of the Comparative Examples. It was confirmed that the carbon nanotubes synthesized using each catalyst exhibited a reduced diameter of 7 to 12 nm and low bulk density.

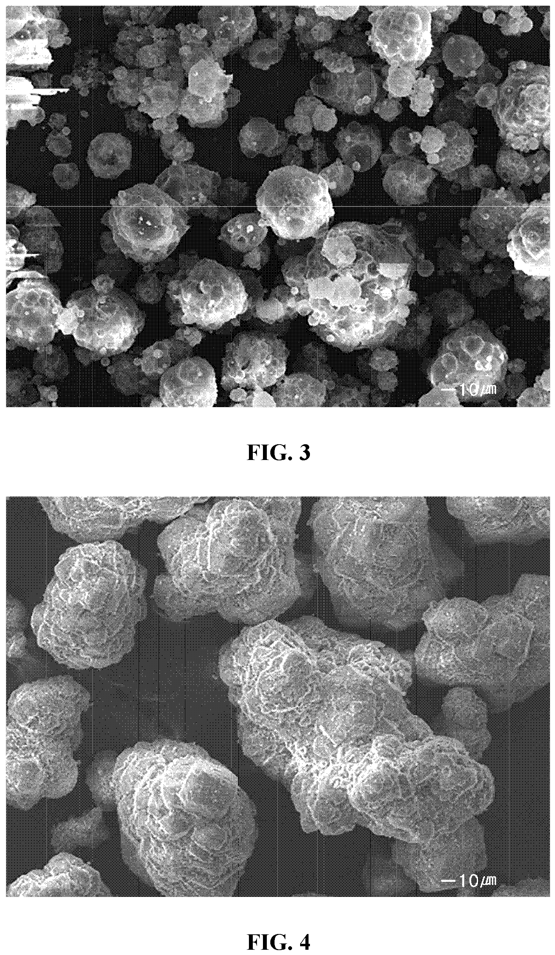

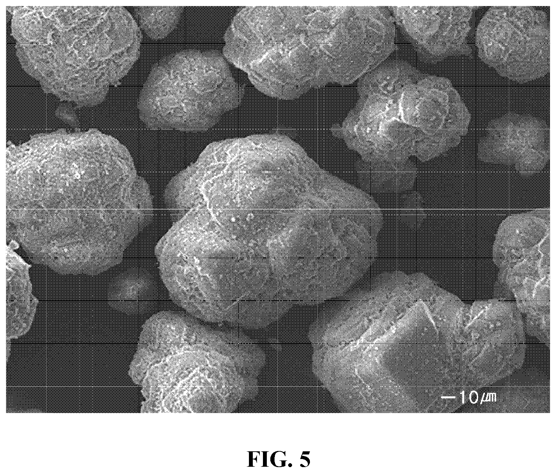

Referring to Table 3 above and Figs. 4 and 5, the supported catalysts prepared according to Comparative Examples 3 and 4 exhibited granular morphology and high bulk density. It was confirmed that the carbon nanotubes synthesized using each catalyst exhibited a diameter exceeding 12 nm and high bulk density.

Despite the fact that Examples 2 and 3 have the same main catalyst and cocatalyst components, and the same mole fraction of the precipitation inhibitor to the cocatalyst precursor as Comparative Examples 3 and 4, respectively, Examples 2 and 3 had different catalyst particle morphology and bulk density due to the difference in the method for preparing the catalyst. Additionally, it was confirmed that when carbon nanotubes were synthesized using the corresponding catalysts, the synthesized carbon nanotubes had different diameter and bulk density.

The foregoing description of the present specification has been presented for illustrative purposes, and it is apparent to a person having ordinary skill in the art that the present specification can be easily modified into other detailed forms without changing the technical idea or essential features of the present specification. Therefore, it should be understood that the forgoing embodiments are by way of example only, and are not intended to limit the present specification. For example, each component which has been described as a unitary part can be implemented as distributed parts. Likewise, each component which has been described as distributed parts can also be implemented as a combined part.

The scope of the present specification is presented by the accompanying claims, and it should be understood that all changes or modifications derived from the definitions and scopes of the claims fall within the scope of the present specification.

**Claims**

1. A method for preparing a catalyst for preparing a carbon nanotube, the method comprising:

   (a) dissolving a main catalyst precursor, a support precursor, a cocatalyst precursor and a precipitation inhibitor in a solvent to prepare a precursor solution; and
   (b) pyrolyzing the precursor solution by spraying the precursor solution into a reactor,

   wherein a mole fraction of the precipitation inhibitor to the cocatalyst precursor is 0.1 to 1.5.

2. The method of claim 1, wherein the main catalyst precursor is at least one metal precursor selected from Co, Fe and Ni.

3. The method of claim 1 or 2, wherein the support precursor is at least one metal precursor selected from Al, Ca and Mg.

4. The method of one of claims 1 to 3, wherein the cocatalyst precursor is at least one metal precursor selected from V, Mn and Mo.

5. The method of one of claims 1 to 4, wherein the precipitation inhibitor is one selected from the group consisting of citric acid, tricarballylic acid, mercaptosuccinic acid, succinic acid and combinations thereof.

6. A catalyst for preparing a carbon nanotube, prepared by the method of any one of claims 1 to 5.

7. The catalyst of claim 6, wherein the catalyst for preparing a carbon nanotube has a bulk density of 0.02 to 0.2 g/ml.

8. The catalyst of claim 6 or 7, wherein the catalyst for preparing a carbon nanotube has a spherical particle morphology.

9. A method for preparing a carbon nanotube, the method comprising:

   (1) introducing the catalyst for preparing a carbon nanotube of claim 6 into a chemical vapor deposition reactor; and
   (2) injecting a carbon source gas to synthesize a carbon nanotube.

10. The method of claim 9, wherein the carbon source gas comprises one selected from the group consisting of unsaturated or saturated hydrocarbon having 1 to 4 carbon atoms, carbon monoxide and mixtures of two or more thereof.

11. A carbon nanotube prepared by the method of claim 9 or 10.

12. The carbon nanotube of claim 11, wherein the carbon nanotube has a diameter of 7 to 12 nm and a bundle length of 50 to 200 $\mu$m.

13. The carbon nanotube of claim 11 or 12, wherein the carbon nanotube has a purity of 90% or more.

14. The carbon nanotube of one of claims 11 to 13, wherein the carbon nanotube has a BET specific surface area of 250 to 400 m$^2$/g.

15. The carbon nanotube of one of claims 11 to 14, wherein the carbon nanotube has a bulk density of 0.005 to 0.5 g/ml.

**FIG. 1**

**FIG. 2**

**FIG. 3**

**FIG. 4**

**FIG. 5**

Europäisches
Patentamt

European
Patent Office

Office européen
des brevets

# EUROPEAN SEARCH REPORT

Application Number

EP 23 20 5033

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 915 676 A1 (NANOCYL [BE]) 1 December 2021 (2021-12-01) * paragraphs [0028], [0055], [0084] – [0087]; claim 8; examples 1,3; tables 1-2 * * the whole document * | 1-15 | INV. C01B32/162 B01J23/74 B01J23/76 B01J35/32 B01J35/51 B01J37/08 H01M10/00 |
| X | KR 2021 0036725 A (LG CHEMICAL LTD [KR]) 5 April 2021 (2021-04-05) * Experimental examples 1 and 3; paragraphs [0084] – [0088], [0096] – [0097], [0107] – [0110]; claims 1-15; examples 1-2; table 2 * * the whole document * | 1-15 | |
| X | US 2020/339421 A1 (SHIMIZU TOSHIAKI [JP] ET AL) 29 October 2020 (2020-10-29) | 11-15 | |
| A | * paragraph [0127] * * the whole document * | 1-10 | |
| X | EP 3 301 745 A1 (LG CHEMICAL LTD [KR]) 4 April 2018 (2018-04-04) | 11-15 | TECHNICAL FIELDS SEARCHED (IPC) |
| A | * table 2 * * the whole document * | 1-10 | C01B B01J H01M |

The present search report has been drawn up for all claims

| Place of search | Date of completion of the search | Examiner |
|---|---|---|
| The Hague | 7 March 2024 | Follens, Lana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 5033

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2024

| Patent document cited in search report | | Publication date | Patent family member(s) | | Publication date |
|---|---|---|---|---|---|
| EP 3915676 | A1 | 01-12-2021 | CA | 3183437 A1 | 02-12-2021 |
| | | | CN | 115666782 A | 31-01-2023 |
| | | | EP | 3915676 A1 | 01-12-2021 |
| | | | EP | 4157518 A1 | 05-04-2023 |
| | | | JP | 2023533655 A | 04-08-2023 |
| | | | KR | 20230017835 A | 06-02-2023 |
| | | | US | 2023294080 A1 | 21-09-2023 |
| | | | WO | 2021239903 A1 | 02-12-2021 |
| KR 20210036725 | A | 05-04-2021 | NONE | | |
| US 2020339421 | A1 | 29-10-2020 | JP | 7272855 B2 | 12-05-2023 |
| | | | JP | 2020180028 A | 05-11-2020 |
| | | | US | 2020339421 A1 | 29-10-2020 |
| EP 3301745 | A1 | 04-04-2018 | CN | 107851801 A | 27-03-2018 |
| | | | EP | 3301745 A1 | 04-04-2018 |
| | | | JP | 6749703 B2 | 02-09-2020 |
| | | | JP | 2018534747 A | 22-11-2018 |
| | | | KR | 20170049459 A | 10-05-2017 |
| | | | PL | 3301745 T3 | 31-01-2020 |
| | | | US | 2018198129 A1 | 12-07-2018 |

EPO FORM P0459

For more details about this annex : see Official Journal of the European Patent Office, No. 12/82